Europäisches Patentamt

European Patent Office

Office européen des brevets

(19)

(11) EP 0 848 866 B1

(12) FASCICULE DE BREVET EUROPEEN

(45) Date de publication et mention
de la délivrance du brevet:
**16.06.1999 Bulletin 1999/24**

(21) Numéro de dépôt: **96931092.9**

(22) Date de dépôt: **09.09.1996**

(51) Int Cl.6: **H03H 17/02**, H04L 25/03

(86) Numéro de dépôt international:
**PCT/FR96/01377**

(87) Numéro de publication internationale:
**WO 97/09781 (13.03.1997 Gazette 1997/12)**

(54) **DISPOSITIF DE FILTRAGE AVEC RETOUR DE DECISION, DANS LE DOMAINE FREQUENTIEL**

FILTERANORDNUNG MIT ENTSCHEIDUNGSRÜCKKOPPLUNG IM FREQUENZBEREICH

DECISION FEEDBACK FILTER DEVICE IN THE FREQUENCY DOMAIN

(84) Etats contractants désignés:
**DE GB**

(30) Priorité: **08.09.1995 FR 9510569**

(43) Date de publication de la demande:
**24.06.1998 Bulletin 1998/26**

(73) Titulaires:
• **FRANCE TELECOM**
**75015 Paris (FR)**
• **TELEDIFFUSION DE FRANCE**
**75015 Paris (FR)**

(72) Inventeurs:
• **BERBERIDIS, Constantinos**
**GR-22441 Patras (GR)**
• **PALICOT, Jacques**
**F-35000 Rennes (FR)**

(74) Mandataire: **Ballot, Paul Denis Jacques**
**Cabinet Ballot-Schmit,**
**7, rue Le Sueur**
**75116 Paris (FR)**

(56) Documents cités:
**EP-A- 0 641 102**

• **SIGNAL PROCESSING 5: THEORIES AND APPLICATIONS. PROCEEDINGS OF EUSIPCO-90 FIFTH EUROPEAN SIGNAL PROCESSING CONFERENCE, BARCELONA, SEPT. 18 - 21, 1990, vol. 1, 18 Septembre 1990, TORRES L; MASGRAU E; LAGUNAS M A (EDS), pages 201-204, XP000358079 SOMMEN P C W: "ON THE CONVERGENCE PROPERTIES OF A PARTITIONED BLOCK FREQUENCY DOMAIN ADAPTIVE FILTER (PBFDAF)"**

## Description

L'invention concerne un dispositif de filtrage d'un signal numérique avec retour de décision, dans le domaine fréquentiel. L'invention trouve une application par exemple dans l'annulation d'échos engendrés par la propagation en trajets multiples, lors d'une transmission hertzienne, notamment d'un signal numérique.

Un problème de grande importance dans les systèmes de transmission terrestres est la distorsion de signal due au phénomène de propagation en trajets multiples. La réflexion d'un signal transmis sur des habitations, sur un relief ou sur différentes couches de l'atmosphère, induit la réception de multiples signaux, ou échos, au lieu d'un seul signal. Les échos indésirables reçus sont généralement déphasés, temporellement décalés et d'amplitudes atténuées par rapport au signal d'origine (tout cela de manière variable dans le temps en fonction du trajet suivi). Ces phénomènes dépendant quant à leur variation principalement des phénomènes météorologiques, ils évoluent lentement pour un système de réception fixe.

En transmission numérique les échos reçus induisent une distorsion des symboles reçus. Cette distorsion se traduit concrètement par un phénomène de recouvrement des symboles, encore appelée interférence entre symboles. Afin d'assurer une réception de haute qualité, l'interférence entre symboles résultante doit être éliminée ou réduite de manière importante.

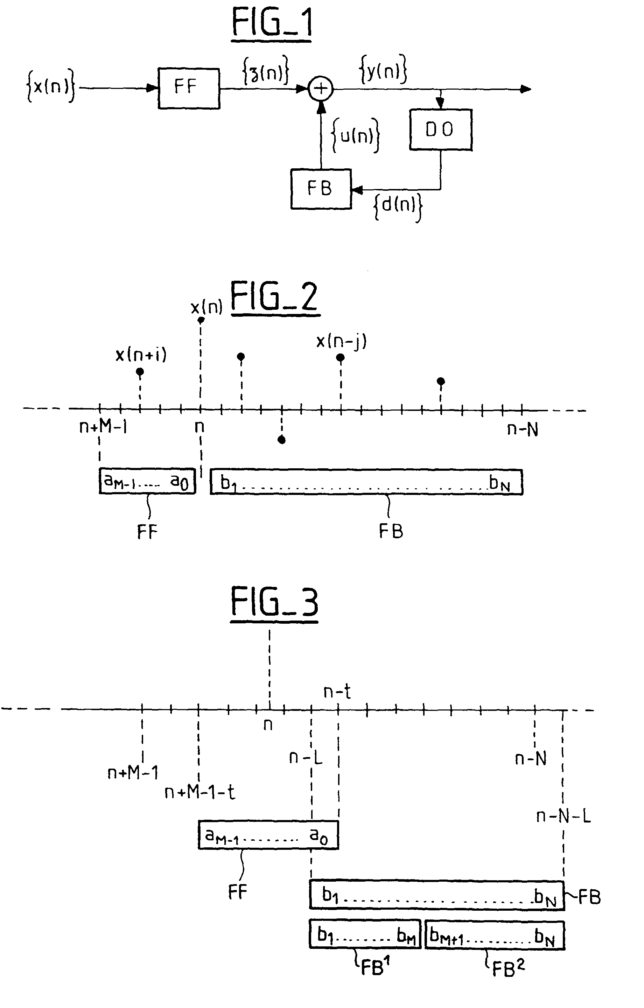

La réponse impulsionnelle d'un canal à trajets multiples s'étend sur un intervalle typique de temps de quelques dizaines de microsecondes. Cet intervalle, qui est fonction de la fréquence utilisée, correspond typiquement à quelques centaines de symboles successifs dans les systèmes de télédiffusion numérique. Un des symboles reçus (voir figure 2) correspond à un symbole $(x(n))$ effectivement émis à l'origine, et les autre symboles $(x(n + i), x(n - j))$ sont des symboles parasites (ou échos) résultant de la propagation en trajets multiples. Une solution de traitement implique l'emploi de filtres numériques d'ordres élevés, c'est à dire à grand nombre de coefficients correctifs, en réception, afin d'éliminer les symboles parasites (et produire, via un organe de décision, une suite de décisions correspondant effectivement aux données émises).

La réponse impulsionnelle échantillonnée d'un canal à trajets multiples peut être mise sous la forme suivante :
$h(t) = \delta(t) + \Sigma_k \alpha_k \delta(t - t_k)$, avec k indice entier de 1 à p, en considérant p trajets, $\alpha_k$ et $t_k$ le gain effectif et le retard temporel respectifs du k-ième trajet, $\delta(t)$ étant l'impulsion émise. Les gains sont généralement complexes. Les retards temporels $t_k$ sont positifs (échos dits postcurseurs) ou négatifs (échos dits précurseurs). En pratique les échos précurseurs sont temporellement très proches du signal relatif au trajet principal (typiquement à une distance temporelle inférieure à 1 microseconde) alors que les échos postcurseurs sont temporellement assez étalés (typiquement reçus avec un retard temporel de 0 à 40 microsecondes).

Comme on l'a vu, le phénomène de propagation en trajets multiples évolue temporellement et il est donc nécessaire d'adapter temporellement les coefficients de filtrage. On utilise dans ce but des filtres dits adaptatifs. Ces filtres adaptatifs comprennent dans leur principe un filtre à coefficients variables et un organe de calcul fournissant ces coefficients au filtre en fonction, d'une part des suites de symboles reçus et produits par le filtre, et d'autre part des suites de décisions correspondantes. Les dispositifs d'adaptation des coefficients de filtrage et sont physiquement découplés dans le cas de fréquences d'échantillonnage élevées (par exemple supérieures à un mégahertz). L'adaptation des coefficients est habituellement réalisée dans un processeur de traitement de signal numérique, ou DSP (Digital Signal Processor), et le filtre est normalement réalisé sur un circuit intégré à haute intégration ou VLSI (Very Large Squale Integration). Une solution de ce type est par exemple décrite dans le document EP-A-0 641 102. Le traitement de type temporel y est classiquement effectué symbole par symbole.

En terme d'adaptation de coefficients, une solution connue est d'utiliser des techniques d'adaptation dite par blocs de symboles: l'élaboration des coefficients est faite à partir de blocs de symboles. On obtient ainsi une convergence plus rapide que dans le cas d'algorithmes en pas à pas. On utilise alors des filtres linéaires rapides pour effectuer l'opération de filtrage, symbole par symbole dans le domaine temporel ou par bloc de symboles dans le domaine fréquentiel. Un tel filtrage linéaire, réalisé dans le domaine fréquentiel, permet par rapport à un filtrage dans le domaine temporel de réduire le nombre de calculs, en remplaçant une convolution temporelle par une multiplication fréquentielle. Une telle solution est par exemple décrite dans l'article "On the convergence properties of a partitioned block frequency domain adaptive filter (PBFDAF) Signal Processing V: Theories and applications; Proceedings of EUSIPCO - 90, Fifth European Signal Processing Conference, Barcelona, Sept 18-21, 1990, Vol.1, 18 September 90, Torres L., Masgrau E., Lagunas M.A. (EDS), pages 201 204.

Néanmoins cette structure de filtrage ne permet pas d'aboutir, avec une complexité abordable, à une correction suffisante dans le cas des échos longs, notamment quand l'étalement temporel des échos dépasse la centaine de symboles

Afin d'améliorer la correction de l'interférence entre symboles, une solution plus avantageuse consiste à utiliser un filtre adaptatif dit à retour de décision, dans le domaine temporel. Un tel filtre, illustré schématiquement figure 1, est constitué de deux filtres temporels, un filtre direct FF et un filtre de contre-réaction FB, recevant chacun en entrée des séries de symboles différentes. L'entrée du filtre direct FF reçoit des symboles $\{x(n)\}$ produits par échantillonnage des signaux reçus, et l'entrée du filtre de contre-réaction reçoit des décisions {d(n)} produites, par un organe de décision DO, à partir des symboles {y(n)} produits après filtrage par le filtre direct FF. Les symboles {y(n)} sont les sorties du filtre total.

Les sorties y(n) sont de la forme :

$$y(n) = z(n) + u(n) \hspace{4cm} (1),$$

où

$z(n) = \Sigma_i \, a_i \, x(n + i)$, avec i variant de 0 à M - 1, représente les symboles produits par le filtre direct FF, celui-ci comprenant M coefficients $a_i$ de pondération, et où

$u(n) = \Sigma_j \, b_j \, d(n - j)$, avec j variant de 1 à N, représente les symboles produits par le filtre de contre-réaction FB à partir des décisions $d(n - 1) = f(y(n - 1))$ à $d(n - N) = f(y(n - N))$, avec f une fonction de décision. Le filtre FB comprend N coefficients $b_j$ de pondération.

Les filtrages des symboles postcurseurs $x(n - j)$ et précurseurs $x(n + i)$ sont donc décorrélés. Le filtre FF est utilisé pour la correction de l'interférence entre symboles induite par les symboles précurseurs. Le filtre de contre-réaction FB est utilisé pour la correction de l'interférence entre symboles induite par les symboles postcurseurs.

Les données d'entrée du filtre de contre-réaction FB étant issues d'un organe de décision, seules les sorties y(n) sont sensibles au bruit. Les filtres à retour de décision sont donc moins sensibles que les filtres linéaires sans rebouclage en présence de bruit.

Les symboles parasites apparaissant principalement dans la partie postcurseur, le nombre M de coefficients correctifs $a_i$ du filtre direct FF est beaucoup plus faible que le nombre N de coefficients correctifs bj du filtre de contre-réaction FB. Typiquement ces nombres sont de l'ordre de M = 30 à 60 coefficients pour le filtre direct FF et de N = 250 à 500 coefficients pour le filtre de contre-réaction FB.

Un tel nombre N de coefficients rend difficile l'intégration des deux filtres sur un circuit intégré commun. On peut éventuellement réduire le nombre de coefficients pour le filtre de contre-réaction FB en utilisant des lignes à retard pour déplacer des groupes de coefficients principalement actifs aux positions estimées des échos. Cette solution est néanmoins difficilement réalisable en pratique, le circuit étant surchargé d'opérations logiques. Une autre solution consiste à utiliser un nombre réduit de coefficients dans le filtre de contre-réaction. L'inconvénient d'une telle autre solution est que la correction de l'interférence entre symboles est de ce fait moins bonne.

Au vu de ce qui précède, un but de l'invention est de mettre en oeuvre un filtrage amélioré, dans lequel la correction de l'interférence entre symboles peut être réalisée sans diminution du nombre de coefficients correctifs, tout en diminuant la complexité des filtres.

La solution proposée par l'invention est de mettre en oeuvre un filtrage avec retour de décision, dans le domaine fréquentiel. Ainsi, on bénéficie à la fois de la faible complexité caractérisant le filtrage dans le domaine fréquentiel (le traitement des symboles étant réalisé par blocs de symboles), tout en bénéficiant des avantages en terme de correction de l'interférence entre symboles du filtrage à retour de décision. En terme de complexité, le filtrage dans le domaine fréquentiel permet de réduire de manière significative le nombre d'opérateurs requis par rapport à un traitement dans le domaine temporel, ce qui facilite l'implantation en VLSI du filtre.

Ainsi, l'invention propose un dispositif de filtrage avec retour de décision comprenant un filtre direct et un filtre de contre-réaction pour produire à partir de symboles d'entrée et de symboles de sortie des décisions correspondantes, le filtre direct recevant en entrée les symboles d'entrée, et le filtre de contre-réaction recevant en entrée les décisions, caractérisé en ce que le filtre direct opère un filtrage dans le domaine fréquentiel de blocs de M symboles d'entrée, et en ce que le filtre de contre-réaction opère un filtrage dans le domaine fréquentiel de blocs de L décisions, avec L inférieur à M.

D'autres particularités et avantages apparaîtront à la lecture de la description qui suit, à lire conjointement aux dessins annexés dans lesquels :

- la figure 1 déjà commentée représente schématiquement un dispositif de filtrage dans le domaine temporel, avec retour de décision,
- la figure 2 représente le phénomène de propagation en trajets multiples et la correction apportée par un dispositif de filtrage dans le domaine temporel avec retour de décision,
- la figure 3 illustre le phénomène de propagation en trajets multiples et la correction apportée par un dispositif de filtrage selon l'invention,
- la figure 4 représente schématiquement un dispositif de filtrage selon l'invention,
- la figure 5 représente schématiquement un premier filtre du dispositif de la figure 4,
- la figure 6 représente schématiquement un deuxième filtre du dispositif de la figure 4,
- la figure 7 représente un dispositif de filtrage adaptatif dans le domaine fréquentiel,

- la figure 8 représente un dispositif de filtrage adaptatif comprenant un organe de calcul de coefficients réalisé avec un filtre à retour de décision de l'invention,
- la figure 9 représente schématiquement un algorithme de mise à jour des coefficients d'un organe de calcul.

Les figures 1 et 2 illustrent le filtrage avec retour de décision dans le domaine temporel.

Un but de l'invention est transposer dans le domaine fréquentiel le filtrage avec retour de décision du domaine temporel, les symboles étant traités par blocs de symboles, et le filtrage dans les filtres direct et de contre-réaction étant réalisé dans le domaine fréquentiel.

Supposons qu'on regroupe les symboles par blocs de M symboles x(n) à x(n + M - 1), ceux ci étant filtrés simultanément afin de produire des blocs de sortie y(n) à y(n + M - 1). La relation (1) définie ci-dessus n'est plus applicable. En effet, pour calculer y(n + 1), on a besoin de d(n) ce qui suppose que l'on connaisse y(n). Il n'est donc pas possible de produire y(n) et y(n + 1) simultanément. Autrement dit, la transposition dans le domaine fréquentiel du filtrage avec retour de décision n'est pas triviale.

Pour résoudre ce problème, l'invention propose de modifier la relation (1) ci-dessus et d'utiliser la relation (2) suivante :

$$y(n) = z(n) + u(n) \qquad (2),$$

avec

$z(n) = \Sigma_i a_i x(n + i - t)$, i variant de 0 à M - 1,
$u(n) = \Sigma_j b_j d(n - j - L)$, j variant de 1 à N,
$t$ et L des entiers.

En considérant L > 1, et en supposant qu'on connaisse les décisions antérieures à d(n), alors on peut calculer les sorties y(n) à y(n + L) simultanément. On peut donc calculer les décisions d(n) à d(n + L). A partir de ces décisions, on peut ensuite calculer les sorties y(n + L + 1) à y(n + 2L) et ainsi de suite.

En choisissant L tel que M = P ∗ L avec P entier, et N tel que N = D ∗ M, avec D un entier, alors le traitement d'un bloc (x(n)...x(n + M - 1)) peut se faire en P étapes successives.

Les sorties y(n) sont produites à partir de trois composantes (voir figure 3) :

$$y(n) = z(n) + u_1(n) + u_2(n) \qquad (3),$$

avec

$z(n) = \Sigma_i a_i x(n + i - t)$, i variant de 0 à M - 1,
$u_1(n) = \Sigma_{j1} b_{j1} d(n - L - j1)$, j1 variant de 1 à M (sous-filtre de contre-réaction FB[1]),
$u_2(n) = \Sigma_{j2} b_{j2} d(n - L - j2)$, j2 variant de M + 1 à N (sous-filtre de contre-réaction FB[2]).

Par rapport à la figure 2, la figure 3 fait apparaître un décalage du filtrage de contre-réaction (formé des deux sous-filtres FB[1] et FB[2] dans la partie postcursive). Autrement dit, les décisions sont fournies au filtre de contre-réaction avec un décalage de L intervalles de temps par rapport à la prise de décision. Le filtre direct est lui-même décalé. En pratique, on choisira $t \geq L$, afin de filtrer les symboles x(n - 1) à x(n - L) dans le filtre direct FF. Par ailleurs le filtre direct FF comprendra en pratique un nombre M' plus important de coefficients, de telle sorte que N + M' - 1 - $t$ soit égal à N + M - 1, afin que pour une application donnée (c'est à dire pour un nombre de symboles postcurseurs donné) le filtrage de la partie postcursive couvre toutes les composantes postcursives.

La relation (3) peut se mettre sous forme matricielle, les indices indiquant les dimensions des vecteurs et l'exposant T signifiant transposé :

$$y_M(n) = z_M(n) + u_M{}^1(n) + u_M{}^2(n) \qquad (4)$$

avec

$$y_M(n) = [y(n) \, ... y(n + M - 1)]^T$$

$$z_M(n) = [z(n)...z(n + M - 1)]^T$$

4

$$u_M^1(n) = [u^1(n)...u^1(n + M - 1)]^T$$

$$u_M^2(n) = [u^2(n)...u^2(n + M - 1)]^T,$$

et
pour j de 0 à M - 1 :

$$z(n + j) = a_M^T(n)\, x_M(n + j + M - t)$$

$$u^1(n + j) = b_M^{1T}(n)\, d_M(n + j - 1)$$

$$u^2(n + j) = b_{N-M}^{2T}(n)\, d_{N-M}(n - M + j - 1)$$

$$y(n + j) = z(n + j) + u^1(n + j) + u^2(n + j),$$

avec

$$x_M(n + j + M - t) = [x(n + M - 1 - t + j)...x(n - t + j)]^T,$$

$$d_M(n + j - 1) = [d(n - L - 1 + j)...d(n - L - M + j)]^T,$$

$$d_{N-M}(n - M + j - 1) = [d(n - L - M - 1 + j)...d(n - L - N + j)]^T.$$

$$a_M(n) = [a_{M-1}...a_0]^T$$

$$b_M^1(n) = [b_1...b_M]^T$$

$$b_{N-M}^2(n) = [b_{M+1}...b_N]^T.$$

Ayant ainsi reformulé le filtrage avec retour de décision dans le domaine temporel de manière à permettre un traitement des symboles par blocs de symboles, l'invention propose de transposer ce filtrage dans le domaine fréquentiel.

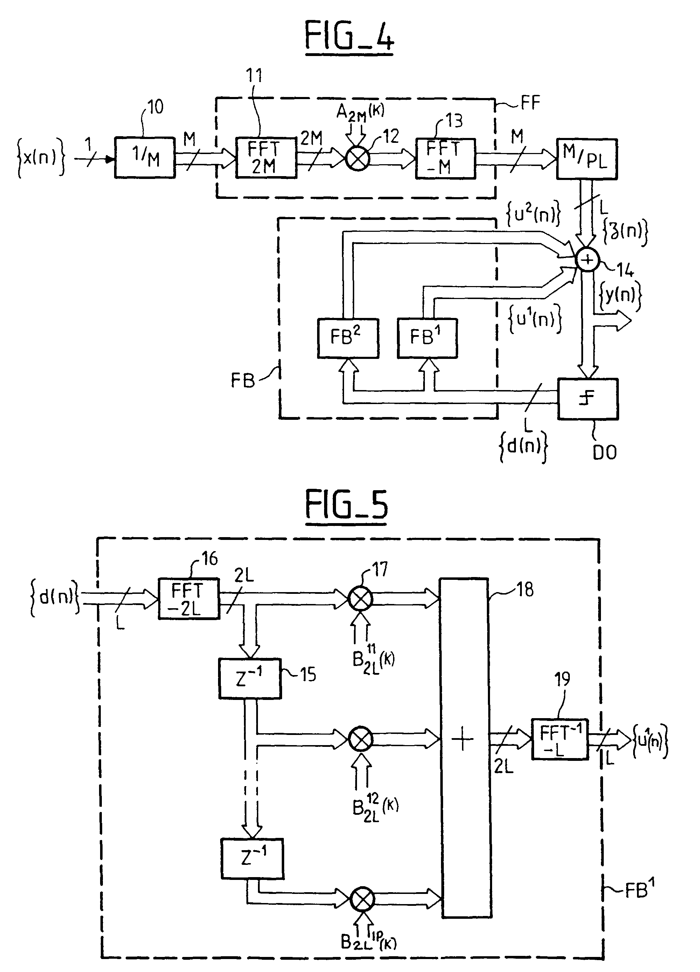

La figure 4 illustre un filtre conforme à l'invention.

Le filtre reçoit en entrée des symboles successifs x(n).

Par conversion série/parallèle 10, les symboles sont regroupés en blocs $x_M(n)$ de M échantillons successifs (x(n)...x(n - M + 1)), k représentant le rang du bloc.

Ces blocs traversent un filtre direct FF 1 d'ordre 2M (correspondant à la transposition en fréquence d'un filtre dans le domaine temporel d'ordre M). Dans l'exemple illustré, ce filtre FF a une structure classique de filtre linéaire rapide dans le domaine fréquentiel. On utilisera par exemple un découpage de l'entrée selon la technique avec recouvrement partiel dite overlap-save, avec un taux de recouvrement de 50%. Après avoir effectué une transformée de Fourier discrète 11 des blocs d'entrée, on les multiplie dans un multiplexeur 12 par un bloc $A_{2M}(k)$ de 2M coefficients de pondération. Puis, par transformation de Fourier inverse 13 on produit en sortie du filtre FF un bloc $z_M(n)$ de M symboles.

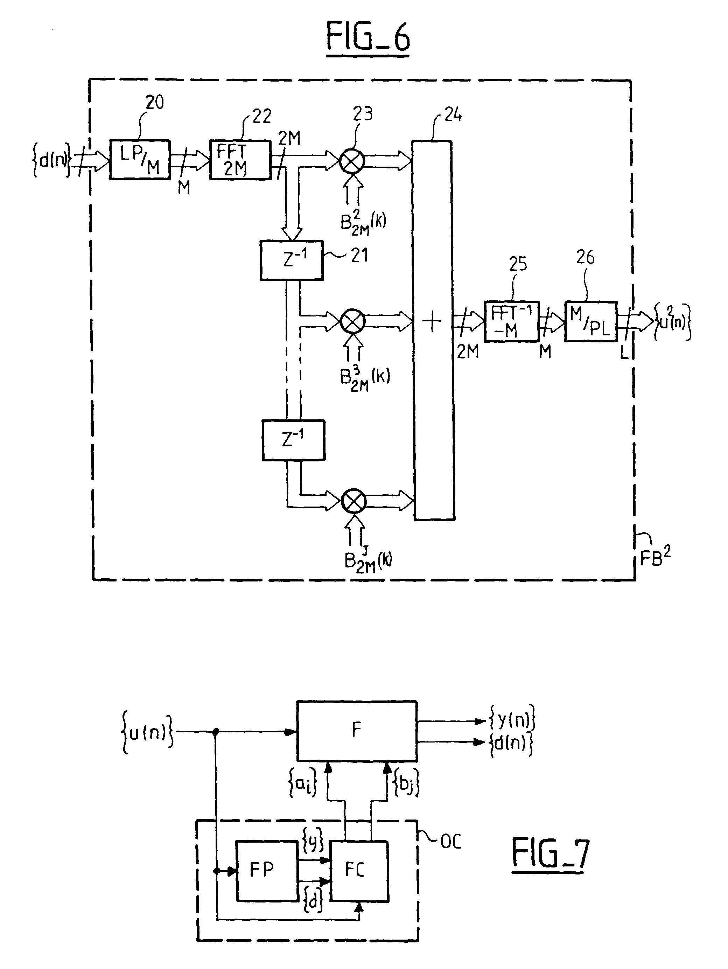

Les sorties y(n) sont calculées en fonction des symboles de sortie du filtre FF et de décisions d(n) produites par un organe de décision DO à partir des sorties précédentes, ces décisions ayant été filtrées par un filtre de contre-réaction FB dans le domaine fréquentiel d'ordre 2N (correspondant à la transposition dans le domaine fréquentiel d'un filtre d'ordre N dans le domaine temporel). Ce filtre de contre-réaction est composé de deux sous-filtres FB$^1$ et FB$^2$ dans le domaine fréquentiel, illustrés respectivement sur les figure 5 et 6.

A partir de ces symboles et de ces décisions d(n) on produit, par une addition 14 dans le domaine temporel, les sorties y(n) correspondantes aux symboles d'entrée x(n).

Les sorties y(n) sont donc obtenues par addition de trois composantes.

Une première composante de la relation (3) est produite par le filtre direct FF. Il s'agit des échantillons de sorties z(n) de ce filtre contenus dans le bloc $z_M$(k).

Une seconde composante, u$^1$(n), est produite par le sous-filtre FB$^1$ qui correspond aux 2M premiers coefficients du filtre FB.

Une troisième composante, u$^2$(n), est produite par le sous-filtre FB$^2$ qui correspond aux 2(N - M) derniers coefficients du filtre FB.

Comme on l'a vu, la difficulté à résoudre est d'obtenir pour chaque bloc de sorties des décisions nécessaires au calcul des sorties, ces décisions correspondant à des sorties du même bloc.

On suppose que l'on connaît les décisions correspondant aux dernières sorties produites.

On partitionne les blocs de symboles de sortie $z_M$(k) en sous-blocs de taille L avec L un entier tel que L = M/P, avec P un entier.

A partir du sous-bloc correspondant aux L premiers symboles de sortie de FF, on produit, par sommation dans le domaine temporel, les L sorties correspondantes (voir relation (3)). A partir de ces sorties, on produit un bloc de L décisions correspondantes dans un organe de décision DO.

Ces décisions sont ensuite traités dans le sous-filtre FB$^1$ correspondant à un filtre linéaire dans le domaine fréquentiel (en utilisant par exemple la technique de recouvrement dite overlap-save avec un taux de recouvrement de 50 %).

Le sous-filtre FB$^1$, figure 5, constitue, au moyen de P circuits de décalage tels que 15, P blocs successifs de 2L symboles (P $*$ L = M) après transformation de Fourier discrète 16 des blocs de L décisions. Les circuits 15 fournissent en sortie des blocs décalés les uns par rapport aux autres d'un intervalle de temps correspondant à L décisions. P multiplieurs 17 effectuent les produits des symboles des P blocs par des coefficients de pondération correspondant regroupés par blocs de 2L coefficients ($B_{2L}^{11}$(n), ..., $B_{2L}^{1P}$(n)). Les multiplieurs fournissent en sortie P blocs de 2L symboles qui sont ensuite sommés en parallèle dans un additionneur 18 dont la sortie fournit 2L symboles. Ces 26 symboles permettent de produire, par une transformation de Fourier discrète inverse 19, un bloc de L symboles u$^1$(n) dans le domaine temporel.

On peut alors produire les L sorties suivantes, par addition en 14 dans le domaine temporel. En renouvelant P fois cette opération, on produit successivement toutes les sorties (et par suite les décisions) correspondant aux M symboles de sortie du filtre direct. Dans un exemple, le sous filtre FB1 (de même que le sous filtre FB2) est du type décrit dans la demande de brevet FR-A-2 702 612. Le sous-filtre FB1, ou le filtre FB en entier, travaillent donc à une fréquence p fois supérieure à celle du filtre direct FF.

Le sous-filtre FB$^2$, figure 6, correspondant aux N - M derniers coefficients de filtrage de contre-réaction dans le domaine temporel, a une structure comparable à celle du sous-filtre FB$^1$. De même que le premier sous-filtre, il produit des blocs de L symboles u$^2$(n) sommés, dans le domaine temporel, aux sous-blocs de L symboles de sortie du filtre direct pour produire les sorties correspondantes. Pour un bloc de M symboles de sortie du filtre direct FF, et à la différence du premier sous-filtre, ces symboles u$^2$(n) sont produits à partir de décisions correspondant au bloc précédent de symboles du filtre direct FF. Autrement dit, il est utilisé de manière similaire à un filtre de contre-réaction de filtre à retour de décision dans le domaine temporel. Les blocs de L décisions reçus de l'organe de décision sont regroupées en une étape 20 par groupes de M, par conversion parallèle/parallèle. Le sous-filtre FB$^2$ constitue, au moyen de circuits à décalage tels que 21, (J - 1) blocs successifs de 2M symboles (avec J tel que J $*$ M = N) après transformation de Fourier 22 des blocs de M décisions. Les circuits à retard 21 fournissent en sortie des blocs décalés les uns par rapport aux autres d'un intervalle de temps correspondant à M décisions. J - 1 multiplieurs 23 effectuent les produits des symboles des blocs par des coefficients de pondération correspondants regroupés par blocs de 2M coefficients ($B_{2M}^{2}$(k),..., $B_{2M}^{J}$(k)). Les multiplieurs 23 fournissent en sortie J - 1 blocs de 2M symboles qui sont ensuite sommés en parallèle dans un additionneur 24 dont la sortie fournit 2M symboles. Ces symboles permettent de produire, par transformation de Fourier discrète inverse 25 et conversion parallèle/parallèle 26, P bloc de L symboles u$^2$(n) dans le domaine temporel. Ces blocs u$^2$(n) sont utilisés pour le calcul des sorties correspondant aux symboles de sortie du filtre direct du bloc suivant celui à partir duquel ils ont été produits.

Le filtre ainsi décrit présente les avantages en terme de complexité des applications de type fréquentiel et les avantages en terme de performance du filtrage avec retour de décision.

Pour corriger l'interférence entre symboles induite par la réception d'échos, les symboles d'entrée (x(n)) étant accompagnés d'échos précurseurs x(n + i) et postcurseurs x(n - j), le filtre direct FF opère un filtrage sur les échos précurseurs, et sur des échos postcurseurs proches, et le filtre de contre-réaction FB opère un filtrage sur les décisions produites à partir des échos postcurseurs, ces décisions étant fournies au filtre de contre-réaction avec un retard de L intervalles de temps, un intervalle de temps étant le délai temporel entre deux symboles successifs. De préférence, le filtre direct opère un filtrage sur les échos postcurseurs dont les décisions correspondantes ne sont pas filtrées par le filtre de contre-réaction, de sorte que l'ensemble des échos postcurseurs et précurseurs soit pris globalement en compte par le filtre total.

Comme on l'a vu, les coefficients de pondération $A_{2M}$ $B_{2L}$ $B_{2M}$ sont de préférence variables dans le temps de manière à adapter la réponse du filtre aux variations du canal de transmission. En pratique, le calcul des coefficients est découplé du filtrage proprement dit. Ce calcul, nécessitant généralement un nombre important d'opérations, il est réalisé la plupart du temps en temps différé par un organe de calcul de type processeur de traitement de signal (ou DSP).

Concrètement, un filtre adaptatif se présente schématiquement sous la forme illustrée figure 7. Les symboles d'entrée {x(n)} reçus sont traités par un filtre F produisant en temps réel, à partir de coefficients de pondération (référencés $a_i$ et $b_j$), des sorties et décisions correspondantes. Le filtre F sera par exemple le filtre illustré sur la figure 4. Les coefficients de pondération sont produits par un organe de calcul OC. A partir des symboles d'entrée, il produit à l'aide d'un filtre préliminaire FP des sorties et décisions correspondantes. Celles ci sont ensuite utilisées par un filtre de calcul FC pour produire les coefficients de pondération qui sont fournis au filtre F.

On peut très bien utiliser des types de filtres différents pour réaliser les filtres F et FP. En pratique c'est souvent le cas. Le filtre F étant utilisé en temps réel, il est indispensable que sa vitesse de traitement soit compatible avec la fréquence symbole. En ce qui concerne le filtre FP de l'organe de calcul, cette contrainte n'est pas présente. On pourra donc réaliser un filtre FP présentant une grande précision, sans se soucier du délai de production des sorties et décisions pourvu que le canal de transmission soit stationnaire pendant la durée de calcul des coefficients. On peut par exemple utiliser pour le filtre FP un filtre dans le domaine fréquentiel, un filtre dans le domaine temporel, ou un filtre à retour de décision.

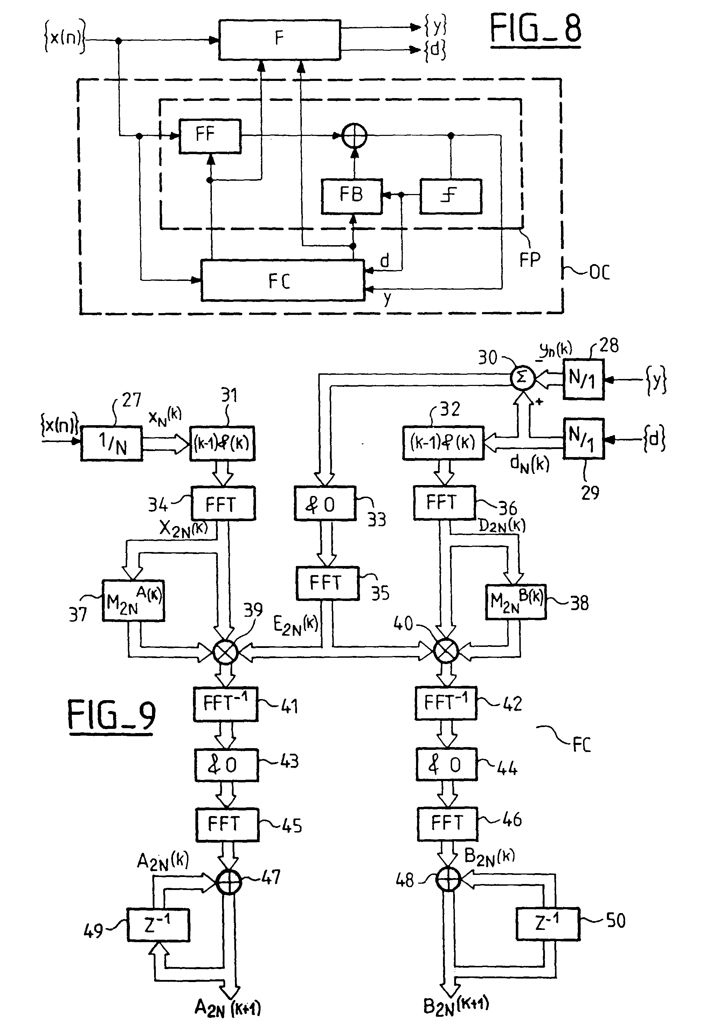

Une solution pour réaliser l'organe de calcul OC est d'utiliser un filtre à retour de décision dans le domaine temporel, tel qu'il est illustré sur la figure 8.

Un algorithme classique d'adaptation des coefficients dans le domaine temporel, en pas à pas, est celui dit des moindres carrés moyens ou LMS (de l'anglais Least Mean Squares) qui peut se mettre sous la forme :

$$a_M(n + 1) = a_M(n) + 2\mu^a.x_M(n + M).e(n),$$

$$b_N(n + 1) = b_N(n) + 2\mu^b.d_N(n).e(n),$$

avec

$e(n) = d(n) - y(n)$ et $\mu^a$ et $\mu^b$ des constantes (représentant un pas de convergence pour le filtre direct et le filtre de contre-réaction).

On connaît déjà des filtres de type LMS dans le domaine fréquentiel (voir par exemple E.R. Ferrara, "Frequency-domain Adaptive Filtering", *Adaptives Filters,* C.F.N. Cowan and P.M. Grant, Eds., Englewood Cliffs, Prentice Hall, 1985, ch. 6, pp. 145 - 179). Une solution pour calculer les coefficients est d'utiliser un filtre FP à retour de décision dans le domaine temporel, en pas à pas, de stocker les sorties et décisions produites, et de réaliser un algorithme de calcul FC dans le domaine fréquentiel de type LMS (en fait l'algorithme de calcul est alors constitué de deux algorithmes de type LMS pour produire respectivement les coefficients du filtre direct et du filtre de contre-réaction).

L'utilisation d'un algorithme FC réalisé selon un perfectionnement de l'invention permet de réduire considérablement la complexité de l'organe de calcul OC. En effet, on peut alors réaliser une adaptation des coefficients dans le domaine fréquentiel, l'organe de calcul comprenant alors un filtre FP réalisé conformément à la figure 4, et un filtre de calcul FC réalisé conformément à la figure 9 à partir d'une nouvelle formulation des algorithmes d'adaptation de sorte que :

$$a_M(n + 1) = a_M(n) + 2\mu^a.x_M(n + M - t).e(n),$$

et

$$b_N(n + 1) = b_N(n) + 2\mu^b\,d_N(n - L).e(n).$$

On pourra, dans la partie adaptative, choisir de travailler sur des blocs de N symboles. Autrement dit l'adaptation des coefficients dans le filtre F est retardé de N intervalles de temps (un intervalle de temps correspondant à l'écart temporel entre deux symboles successifs). En pratique, on pourra même retarder l'adaptation des coefficients dans le filtre F de plusieurs blocs de N symboles si l'environnement est supposé stationnaire pour quelques millisecondes (ce qui correspond dans des applications classiques, à quelques dizaines de blocs de N symboles).

On va maintenant décrire l'algorithme de calcul FC illustré sur la figure 9. Pour faciliter la compréhension du lecteur, on utilisera un formalisme mathématique. Concrètement, cet algorithme sera typiquement réalisé sous la forme d'un processeur de traitement de signal (ou DSP).

Les symboles $x(n)$, $y(n)$ et $d(n)$ sont regroupés dans des convertisseurs série parallèle 27-29, par blocs $x_N(k) = (x(kN + M - t)...x(kN + M - t + N - 1))$, $y_N(k) = (y(kN - L)...y(kN - L + N - 1))$ et $d_N(k) = (d(kN - L)....d(kN - L + N - 1))$ de N symboles et décision successifs. A partir des blocs $y_N(k)$ et $d_N(k)$, on produit par un sommateur 30 un bloc d'erreurs $e_N(k) = d_N(k) - y_N(k)$.

A partir des k-ième blocs $x_N(k)$ et $d_N(k)$ on produit dans des concaténateurs 31-32 des blocs de 2N éléments par concaténation avec les (k -1)-ièmes blocs correspondants, le bloc $e_N(k)$ étant lui complété par N zéros dans un concaténateur 33.

On passe ensuite dans le domaine fréquentiel par des transformations 34-36 de Fourier discrètes. On produit ainsi des matrices $X_{2N}(k)$, $D_{2N}(k)$ et $E_{2N}(k)$ telles que :

$$X_{2N}(k) = \text{diag}\{\text{FFT}[x_N(k\text{-}1): x_N(k)]^T\}$$

$$D_{2N}(k) = \text{diag}\{\text{FFT}[d_N(k\text{-}1): d_N(k)]^T\}$$

$E_{2N}(k) = \text{FFT}\{ Q^{0T}e_N(k)\}$ avec $Q^{0T} = [O_N: I_N]$, $O_N$ et $I_N$ étant respectivement les matrices carrée identiquement nulle et identité de dimension N; : signifiant une concaténation par juxtaposition; diag signifiant la matrice diagonale; et FFT signifiant l'opération de transformée de Fourier discrète.

On remarquera que les matrices sont en pratique des blocs de 2N éléments représentés mathématiquement, par soucis de concision, par des matrices diagonales de dimension 2N.

On produit ensuite dans des filtres récursifs 37 et 38 des matrices de dimension 2N notées $M_{2N}^A(k)$ et $M_{2N}^B(k)$ telles que :

$$M_{2N}^A(k) = 2\mu^a.\text{diag}\{[P_1^{-x}(k), ..., P_{2N}^{-x}(k)]^T\}$$

$$M_{2N}^B(k) = 2\mu^b.\text{diag}\{[P_1^{-d}(k), ..., P_{2N}^{-d}(k)]^T\},$$

avec

$$P_{2N}^x(k) = \lambda P_{2N}^x(k - 1) + (1 - \lambda )X_{2N}^H(k).X_{2N}(k)1_{2N}$$

$$P_{2N}^d(k) = \lambda P_{2N}^d(k - 1) + (1 - \lambda )D_{2N}^H(k).D_{2N}(k)1_{2N}$$

$1_{2N}$ étant un vecteur de dimension 2N ayant tous ses éléments à 1 pour obtenir un vecteur en résultat, $\lambda$ étant un facteur d'oubli inférieur à un, H signifiant la transposée, et $\text{diag}P_1^{-x}(k)$ signifiant la constitution d'une matrice diagonale dont les termes non nuls sont les inverses (d'où l'exposant -) des composantes du vecteur $X_1(k)$, ... , $X_2N(k)$, de même pour $\text{diag}P_1$-d(k) avec le vecteur $D_1(k)$ ... , $D_{2N}(k)$. En utilisant deux multiplieurs 39, 40, on produit ensuite les matrices $M_{2N}^{AX}(k) = M_{2N}^A(k).X_{2N}^H(k).E_{2N}$ et $M_{2N}^{BD}(k) = M_{2N}^A(k).D_{2N}^H(k).E_{2N}$.

Les matrices diagonales $M_{2N}^{AX}(k)$ et $M_{2N}^{BD}(k)$ sont ensuite transposées dans le domaine temporel par transformée de Fourier discrètes inverses 41 42.

On annule dans des concaténateurs 43 44 les 2N - M derniers éléments du bloc $M_{2N}^{AX}(k)$ et les N derniers éléments de $M_{2N}^{BD}(k)$, ce qui consiste, mathématiquement, à calculer $Q^M.M_{2N}^{AX}(k)$ et $Q^N M_{2N}^{BD}(k)$, avec

$$Q^M = \begin{vmatrix} I_{M*M} & O_{M*2N-M} \\ O_{2N-M*M} & O_{2N-M*2N-M} \end{vmatrix}$$

et

$$Q^N = \begin{vmatrix} & I_{N*N} & O_{N*N} \\ & & \\ & O_{N*N} & O_{N*N} \end{vmatrix}.$$

Les blocs sont ensuite transposés en 45 46 dans le domaine fréquentiel par transformation de Fourier discrète.

Il suffit, pour produire $A_{2N}(k+1)$ et $B_{2N}(k+1)$, d'utiliser deux additionneurs 47 48 et deux circuits à retard 49 50 de sorte qu'on réalise le calcul suivant :

$$A_{2N}(k+1) = A_{2N}(k) + FFT(Q^M M_{2N}^{AX}(k)),$$

$$B_{2N}(k+1) = B_{2N}(k) + FFT(Q^N M_{2N}^{BD}(k)).$$

Concrètement, on produit deux blocs de 2N éléments (formés des éléments diagonaux des matrices $A_{2N}(k+1)$ et $B_{2N}(k+1)$).

## Revendications

1. Dispositif de filtrage avec retour de décision comprenant un filtre direct (FF) et un filtre de contre-réaction (FB) pour produire à partir de symboles d'entrée (x(n)) des décisions (d(n)) correspondantes, le filtre direct (FF) recevant en entrée les symboles d'entrée, et le filtre de contre-réaction (FB) recevant en entrée les décisions (d(n)), caractérisé en ce que le filtre direct (FF) opère un filtrage dans le domaine fréquentiel de blocs de M symboles d'entrée, et en ce que le filtre de contre-réaction (FB) opère un filtrage dans le domaine fréquentiel de blocs de L décisions, avec L inférieur à M.

2. Dispositif selon la revendication 1, caractérisé en ce que le filtre direct (FF) produit des blocs de M symboles de sortie (z(n)), ces blocs étant convertis en sous-blocs de L symboles de sortie, ces sous-blocs étant combinés à des blocs de L symboles ($u^1(n)$), $u^2(n)$) produits par le filtre de contre-réaction (FB) pour produire des sorties (y(n)) à partir desquelles sont produites les décisions (d(n)).

3. Dispositif selon la revendication 2, caractérisé en ce que les sorties (y(n)) sont produites par addition dans le domaine temporel des sous-blocs de symboles de sortie (z(n)) avec les blocs de symboles produits par le filtre de contre-réaction (FB).

4. Dispositif selon l'une des revendications 1 à 3, caractérisé en ce que le filtre de contre-réaction (FB) comprend un premier et un deuxième sous-filtres ($FB^1$, $FB^2$), le premier sous-filtre ($FB^1$) opérant un filtrage sur les blocs de L décisions, et le deuxième sous-filtre ($FB^2$) opérant un filtrage sur des blocs de M décisions après conversion des blocs de L décisions en blocs de M décisions, les symboles ($u^2(n)$) produits par ce deuxième sous-filtre étant convertis en blocs de L décisions en sortie de ce sous-filtre.

5. Procédé de correction de l'interférence entre symboles induite par la réception d'échos avec un dispositif de filtrage défini selon l'une des revendications 1 à 4, les symboles d'entrée (x(n)) étant accompagnés d'échos précurseurs (x(n + i)) et postcurseurs (x(n + j)), caractérisé en ce que le filtre direct (FF) opère un filtrage sur les échos postcurseurs et en ce que le filtre de contre-réaction (FB) opère un filtrage sur les décisions produites à partir des échos postcurseurs, ces décisions étant fournies au filtre de contre-réaction avec un retard de L intervalles de temps, un intervalle de temps étant le délai temporel entre deux symboles successifs.

6. Procédé selon la revendication 5, caractérisé en ce que le filtre direct opère un filtrage sur les échos postcurseurs dont les décisions correspondantes ne sont pas filtrées par le filtre de contre-réaction.

7. Dispositif de filtrage adaptatif comprenant un organe de calcul (OC) pour produire des coefficients de pondération, l'organe de calcul comprenant un filtre préliminaire (FP) pour produire des sorties et des décisions à partir de symboles d'entrée, et un filtre de calcul (FC) pour produire les coefficients de pondération à partir de ces données, caractérisé en ce que le filtre préliminaire est un dispositif de filtrage défini selon l'une des revendications 1 à 4.

8. Dispositif selon la revendication 7, caractérisé en ce que le filtre de calcul produit les coefficients de pondération dans le domaine fréquentiel selon la méthode des moindres carrés moyens.

**Claims**

1. Filtering device with a decision feedback comprising a direct filter (FF) and a feedback filter (FB) for producing, from input symbols (x(n)), corresponding decisions (d(n)), the direct filter (FF) receiving the input symbols as an input, and the feedback filter (FB) receiving the decisions (d(n)) as an input, characterised in that the direct filter (FF) effects a filtering in the frequency domain of blocks of M input symbols, and in that the feedback filter (FB) effects a filtering in the frequency domain of blocks of L decisions, with L less than M.

2. Device according to Claim 1, characterised in that the direct filter (FF) produces blocks of M output symbols (z(n)), these blocks being converted into sub-blocks of L output symbols, these sub-blocks being combined with blocks of L symbols $(u^1(n))$, $(u^2(n))$ produced by the feedback filter (FB) in order to produce outputs (y(n)) from which the decisions (d(n)) are produced.

3. Device according to Claim 2, characterised in that the outputs (y(n)) are produced by adding, in the time domain, sub-blocks of output symbols (z(n)) with the blocks of symbols produced by the feedback filter (FB).

4. Device according to one of Claims 1 to 3, characterised in that the feedback filter (FB) comprises first and second subfiltering $(FB^1, FB^2)$, the first sub-filter $(FB^1)$ effecting a filtering on the blocks of L decisions, and the second sub-filter $(FB^2)$ effecting a filtering on blocks of M decisions after conversion of the blocks of L decisions into blocks of M decisions, the symbols $(u^2(n))$ produced by the second sub-filter being converted into blocks of L decisions at the output of this sub-filter.

5. Method of correcting interference between symbols caused by the reception of echoes with a filtering device defined according to one of Claims 1 to 4, the input symbols (x(n)) being accompanied by precursor echoes (x(n+i)) and postcursor echoes (x(n+j)), characterised in that the direct filter (FF) effects a filtering on the postcursor echoes and in that the feedback filter (FB) effects a filtering on the decisions produced from the postcursor echoes, these decisions being supplied at the feedback filter with a delay of L time intervals, a time interval being the time delay between two successive symbols.

6. Method according to Claim 5, characterised in that the direct filter effects a filtering on the postcursor echoes whose corresponding decisions are not filtered by the feedback filter.

7. Adaptive filtering device comprising a calculation unit (OC) for producing weighting coefficients, the calculation unit comprising a preliminary filter (FP) for producing outputs and decisions from input symbols, and a calculation filter (FC) for producing the weighting coefficients from these data, characterised in that the preliminary filter is a filtering device defined according to one of Claims 1 to 4.

8. Device according to Claim 7, characterised in that the calculation filter produces the weighting coefficients in the frequency domain according to the least mean squares method.

**Patentansprüche**

1. Vorrichtung zum Filtern mit Rückgabe der Entscheidung mit einem Vorwärtsfilter (FF) und einem Gegenkopplungsfilter (FB) zum Erzeugen von entsprechenden Entscheidungen (d(n)) aus Eingangssymbolen (x(n)), wobei das Vorwärtsfilter (FF) am Eingang die Eingangssymbole empfängt und das Gegenkopplungsfilter (FB) am Eingang die Entscheidungen (d(n)) empfängt, dadurch gekennzeichnet, daß das Vorwärtsfilter (FF) eine Filterung in dem Frequenzbereich von Eingangsblöcken mit M Symbolen durchführt und daß das Rückkopplungsfilter (FB) eine Filterung im Frequenzbereich von Blöcken mit L Entscheidungen, wobei L kleiner als M, durchführt.

**2.** Vorrichtung nach Anspruch 1, dadurch gekennzeichnet, daß das Vorwärtsfilter (FF) Ausgangsblöcke z(n)) mit M Symbolen erzeugt, wobei diese Blöcke in Ausgangsteilblöcke mit L Symbolen konvertiert werden und diese Teilblöcke mit Blöcken ($u^1$(n), ($u^2$(n)) kombiniert werden, die durch das Gegenkopplungsfilter (FB) erzeugt wurden, um Ausgänge (y(n)) zu erzeugen, aus denen die Entscheidungen (d(n)) erzeugt werden.

**3.** Vorrichtung nach Anspruch 2, dadurch gekennzeichnet, daß die Ausgänge (y(n)) erzeugt werden durch Addition von Ausgangsteilblöcken (z(n)) mit Symbolen im Zeitbereich, wobei die Blöcke mit Symbolen durch das Gegenkopplungsfilter (FB) erzeugt worden sind.

**4.** Vorrichtung nach einem der Ansprüche 1 bis 3, dadurch gekennzeichnet, daß das Gegenkopplungsfilter (FB) ein erstes und ein zweites Teilfilter ($FB^1$, $FB^2$) umfaßt, wobei das erste Teilfilter ($FB^1$) eine Filterung der Blöcke mit L Entscheidungen durchführt und das zweite Teilfilter ($FB^2$) eine Filterung der Blöcke mit M Entscheidungen nach Konvertierung von Blöcken mit L Entscheidungen in Blöcke mit M Entscheidungen durchführt, wobei die Symbole ($u^2$(n)), die durch das zweite Teilfilter erzeugt worden sind, in Ausgangsblöcke mit L Entscheidungen von diesem Teilfilter konvertiert werden.

**5.** Verfahren zum Korrigieren von Interferenzen zwischen Symbolen, die durch den Empfang von Echos hervorgerufen werden, mit einer Vorrichtung zum Filtern nach einem der Ansprüche 1 bis 4, wobei die Eingangssymbole (x(n)) begleitet werden von Vorechos (x(n + i)) und Nachechos (x(n + j)), dadurch gekennzeichnet, daß das Vorwärtsfilter (FF) eine Filterung der Nachechos durchführt und daß das Gegenkopplungsfilter (FB) eine Filterung der aus den Nachechos erzeugten Entscheidungen durchführt, wobei diese Entscheidungen an das Gegenkopplungsfilter mit einer Verzögerung von L Zeitintervallen ausgegeben werden, wobei ein Zeitintervall die zeitliche Verzögerung zwischen zwei aufeinanderfolgenden Symbolen ist.

**6.** Verfahren nach Anspruch 5, dadurch gekennzeichnet, daß das Vorwärtsfilter eine Filterung der Nachechos durchführt, wobei die entsprechenden Entscheidungen nicht durch das Gegenkopplungsfilter gefiltert werden.

**7.** Vorrichtung zum adaptiven Filtern mit einer Recheneinheit (OC) zum Erzeugen von Wichtungskoeffizienten, wobei die Recheneinheit ein Vorfilter (FP) zum Erzeugen von Ausgängen und Entscheidungen aus Eingangssymbolen und ein Rechenfilter (FC) zum Erzeugen von Wichtungsfaktoren aus diesen Daten umfaßt, dadurch gekennzeichnet, daß das Vorfilter eine Filtervorrichtung nach einem der Ansprüche 1 bis 4 ist.

**8.** Vorrichtung nach Anspruch 7, dadurch gekennzeichnet, daß das Rechenfilter die Wichtungskoeffizienten im Frequenzbereich nach dem Verfahren des kleinsten quadratischen Mittels erzeugt.

FIG_1

FIG_2

FIG_3

## FIG_4

## FIG_5

## FIG_6

## FIG_7

FIG_8

FIG_9